# EUROPÄISCHE PATENTSCHRIFT

(11) **EP 1 320 290 B1**
(45) Veröffentlichungstag und Bekanntmachung des Hinweises auf die Patenterteilung: **12.05.2010**
(21) Anmeldenummer: 02025453.8
(22) Anmeldetag: 15.11.2002
(51) Int. Cl.: H05K 7/14, H05K 5/02

(54) **Verteilerkasten**
Distribution box
Boîtier de distribution

(30) Priorität: 13.12.2001 DE 20120176 U
(43) Veröffentlichungstag der Anmeldung: 18.06.2003
(73) Patentinhaber: Weidmüller Interface GmbH & Co. KG, 32758 Detmold (DE)
(72) Erfinder: Reker, Stefan, 33659 Bielefeld (DE); Sigg, Daniel, 8232 Merishausen (CH)
(74) Vertreter: Specht, Peter

(56) Entgegenhaltungen:
- EP-A- 0 863 691
- EP-A- 0 909 121
- DE-A- 19 715 437
- US-A- 4 778 949
- US-A- 5 317 105
- US-A- 5 511 990

## Beschreibung

Steuerungseinheit außerhalb des Verteilers in das innere des Anschlusskastens 1 geführt.

Im Anschlusskasten sind ferner zwei Durchbrüche 8 ausgebildet, welche eine der Geometrie eines schweren Steckverbinders angepasste Geometrie aufweisen.

Durch die zwei Durchbrüche sind 8 sind jeweils vorzugsweise als schwere Steckverbinder ausgebildete Steckerteile 9 führbar, welche direkt an den Boden 10 der Gehäuse 11 der Verteiler 12 angesetzt oder angeformt sind. Die Gehäuse 11 der Verteiler 12 weisen an den vom jeweiligen Boden 10 abgewandten Außenbereich die hier nicht erkennbaren Anschlüsse zum Anschluss externer Sensoren und/oder Aktoren auf.

Die vorzugsweise passiven Verteiler 12 werden derart angebracht und/oder ausgelegt, dass die Durchbrüche 8 gegen das Eindringen von Feuchtigkeit abgedichtet sind. Das Steckerteil 9 - insbesondere ein Flachbandsteckerteil - kann dann von innen kontaktiert werden. Das Steckerteil 9 wird insbesondere derart ausgelegt, dass es den bei der Verkabelung der Steuerung bevorzugt angepassten Steckerauslegung entspricht.

Das Gegensteckerteil 13 ist jeweils als eine an einem Kabel 14 von der Steuerungseinrichtung angebrachte Steckerbuchse ausgebildet. Die Verbindung zwischen der Steuerungseinrichtung 4 im inneren des Anschlusskastens 1 oder Schaltschrankes kann auf diese Weise ausschließlich durch ein Zusammenstecken der Elemente Verteiler 12 und Gegensteckerteil 13 realisiert werden.

### Bezugszeichen

- Anschlusskasten: 1
- Tragschienenstücke: 2, 3
- Steuerungseinrichtung: 4
- Klemmenblock: 5
- Durchführung: 6
- Kabel: 7
- Durchbrüche: 8
- Steckerteile: 9
- Boden: 10
- Gehäuse: 11
- Verteiler: 12
- Gegensteckerteil: 13
- Kabel: 14

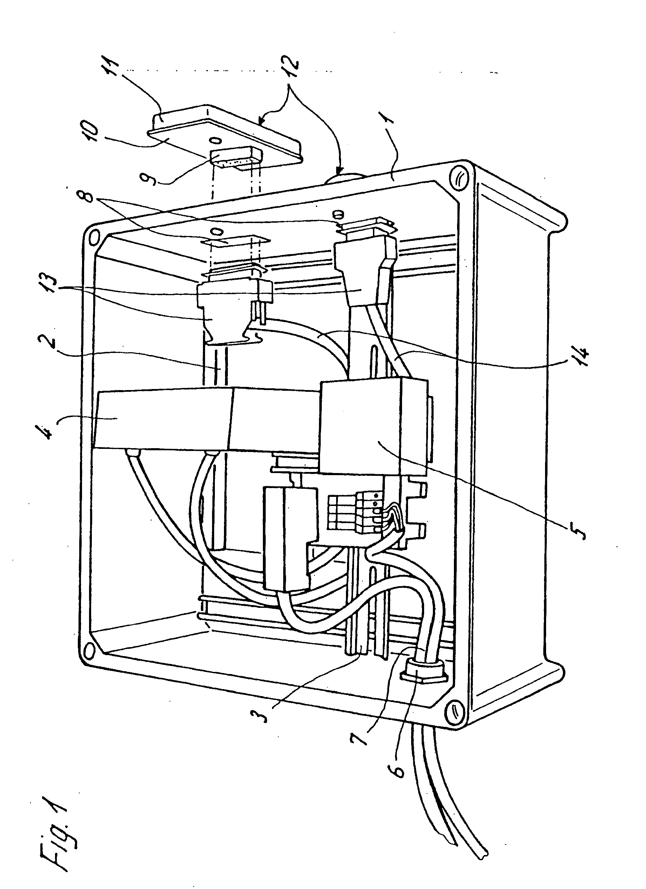

## Patentansprüche

1. Verteiler mit Anschlusskasten zur Aufnahme einer Steuerungseinrichtung (4), wobei der Verteiler
a) ein Gehäuse (11) mit einem Anschlussbereich mit Anschlüssen für externe elektrische Geräte wie Sensoren und/oder Aktoren und einen Anschluß für eine Steuerungseinrichtung - eine speicherprogrammierbare Steuerung (SPS) aufweist,
b) über ein Kabel (14) mit der innerhalb des Anschlußkastens (1) angeordneten Steuerungseinrichtung verbindbar ist,
c) wobei direkt an den Boden (10) des Verteilers (12) ein Steckerteil (9) angesetzt und/oder angeformt ist,
d) das dazu ausgelegt ist, einen Durchbruch (8) in der Außenwandung des Anschlußkastens (1) zu durchsetzen und das im Inneren des Anschlusskastens (1) von einem Gegensteckerteil (13) kontaktierbar ist, so dass der Verteiler direkt mit dem Boden an eine Außenwand des Anschlußkastens ansetzbar ist,
**dadurch gekennzeichnet, dass**
e) der Verteiler ein Aktor Sensor Interface Verteiler mit passiver Auslegung ist,
f) zwischen dem Steckerteil am Verteiler und/oder dem Verteilergehäuse und der Außenwandung des Verteilerkastens eine Dichtung angeordnet ist und/oder die Verbindung auf andere Weise abgedichtet ausgestaltet ist, und
g) das Steckerteil (9) am Verteiler (12) als Flachbandkabelstecker und das Gegensteckerteil (13) als damit korrespondierende Flachbandkabelbuchse ausgebildet ist oder dass das Steckerteil (9) am Verteiler (12) als Flachbandkabelbuchse und das Gegensteckerteil (13) als korrespondierende Flachbandkabelbuchse ausgebildet ist.

2. Verteiler mit Anschlusskasten, nach einem der vorstchenden Ansprüche, **dadurch gekennzeichnet, dass** der Anschlusskasten (1) eine im Wesentlichen rechtwinklige Form aufweist und aus Kunststoff besteht.

## Claims

1. Distributor with terminal box for the accommodation of a control unit (4), wherein the distributor
a) comprises a housing (11) having connecting regions with connections for external electrical devices such as sensors and/or actuators and a connection for a control unit - a programmable logic controller (PLC),
b) can be connected via a cable (14) to the control unit housed in the terminal box (1),
c) wherein a plug part (9) is directly fitted and/or moulded to the base (10) of the distributor,
d) said plug part being designed to pass through a through-opening in the outer wall of the terminal box (1) and being contactable in the interior of the terminal box (1) by a mating plug part (13), so that the distributor can be fitted directly to an outer wall of the terminal box by its base,
**characterised in that**
e) the distributor is an actuator/sensor interface of a passive design,
f) a seal is provided between the plug part on the distributor and/or the distributor housing and the outer wall of the distributor box and/or the joint is sealed by other means, and
g) the plug part (9) on the distributor (12) is designed as a flat ribbon cable plug and the mating plug part (13) is designed as a matching flat ribbon cable socket or **in that** the plug part (9) on the distributor (12) is designed as a flat ribbon cable socket and the mating plug part (13) is designed as a matching flat ribbon cable plug.

2. Distributor with terminal box according to claim 1, **characterised in that** the terminal box has a substantially rectangular shape and is made of plastic.

## Revendications

1. Distributeur avec un boîtier de branchement destiné à recevoir un dispositif de commande (4), ledit distributeur
a) comportant un boîtier (11) muni d'une zone de raccordement avec des branchements pour des appareils électriques externes, tels que des capteurs et/ou des actionneurs, et un branchement pour un dispositif de commande - une commande programmable -,
b) étant propre à être raccordé par l'intermédiaire d'un câble (14) au dispositif de commande monté à l'intérieur du boîtier de branchement (1),
c) un élément de connexion étant posé et/ou formé directement contre le fond (10) du distributeur (12),
d) lequel est configuré pour passer à travers un ajour (8) dans la paroi extérieure du boîtier de branchement (1) et lequel peut être mis en contact à l'intérieur du boîtier de branchement (1) par un élément de connexion complémentaire (13), de telle sorte que le distributeur peut être posé directement avec le fond contre une paroi extérieure du boîtier de branchement,
**caractérisé en ce que**
e) le distributeur est une interface actionneur-capteur à configuration passive,
f) une garniture d'étanchéité est agencée entre l'élément de connexion sur le distributeur et/ou le boîtier du distributeur et la paroi extérieure du boîtier de distributeur, et/ou l'assemblage est réalisé de manière étanche d'une autre manière, et
g) l'élément de connexion (9) sur le distributeur (12) est réalisé sous la forme d'une prise de courant mâle à câble plat et l'élément de connexion complémentaire (13) est réalisé sous la forme d'une prise de courant femelle à câble plat correspondante, ou **en ce que** l'élément de connexion (9) sur le distributeur est réalisé sous la forme d'une prise de courant femelle à câble plat correspondante et l'élément de connexion complémentaire (13) est réalisé sous la forme d'une prise de courant mâle à câble plat correspondante.

2. Distributeur avec un boîtier de branchement, selon revendication 1, **caractérisé en ce que** le boîtier de branchement (1) a une forme sensiblement rectangulaire et est réalisé en matière plastique.
